# EUROPEAN PATENT SPECIFICATION

(11) **EP 3 997 965 B1**
(45) Date of publication and mention of the grant of the patent: **18.03.2026**
(21) Application number: 19937103.0
(22) Date of filing: 16.07.2019
(51) Int. Cl.: H05H 1/50, C23C 14/24, C23C 14/32, H01J 37/32, H01J 37/34

(54) **VACUUM ARC CATHODE SOURCE OF PLASMA WITH ENHANCED MAGNETIC FIELD CONFIGURATION AND METHOD OF ITS OPERATION**
VAKUUMBOGEN-KATHODENQUELLE FÜR PLASMA MIT VERBESSERTER MAGNETFELDKONFIGURATION UND VERFAHREN ZU DEREN BETRIEB
SOURCE À ARC À VIDE DE PLASMA CATHODIQUE AVEC CONFIGURATION DE CHAMP MAGNÉTIQUE AMÉLIORÉE ET SON PROCÉDÉ DE FONCTIONNEMENT

(30) Priority: 11.07.2019 WO PCT/SK2019/050007
(43) Date of publication of application: 18.05.2022
(73) Proprietor: Staton S.R.O., 03853 Turany (SK)
(72) Inventor: MORGOS , Ivan, 03853 Turany (SK); BALLO, Valdimír, 03406 Ruzomberok (SK); IZAI, Vitalii, 88017 Uzhorod (SK)
(74) Representative: Belicka, Ivan
(86) International application number: PCT/SK2019/050007
(87) International publication number: WO 2021/006821

(56) References cited:
- WO-A2-00/62327
- CN-A- 102 936 717
- CN-A- 102 936 717
- CN-A- 102 953 035
- CN-A- 102 953 035
- CN-B- 103 205 711
- US-A- 5 430 355
- US-A1- 2011 315 544

## Description

### FIELD OF TECHNOLOGY

The present invention relates to plasma sources for vacuum-plasma treatment of surfaces, as well as for application of protective and wear resistant coatings with enhanced mechanical properties. The present invention relates to a plasma source utilizing a cathodic vacuum arc discharge and a method for operating it, wherein the source provides precise control of an arc discharge and increased cathode spot velocity.

### PRIOR ART

Cathodic vacuum arc plasma deposition technique is widely used for the surface treatment in a modem industry of tools for material processing. The hard coatings obtained by condensation from highly ionized metallic plasma demonstrate remarkable properties (such as adhesion to various types of substrates, high values of hardness, long lifetime etc.) in comparison to conventional magnetron sputtering, hard chrome plating or CVD methods. The structure of obtained films can be widely varied from the highly oriented columnar one to nanocomposite by varying the chemistry and deposition parameters, maintaining at the same time a high density of resulting coatings. At the same time the technique, mentioned above, can be characterized as a cheap technology in comparison with such novel methods, as HiPIMS, thanks to utilization of low-cost welding power supplies instead of complicate and unreliable HiPIMS units, which can provide coatings with similar physical properties but are still in the development stage. In addition, the cathodic arc plasma deposition technique demonstrates one of the highest deposition rates among PVD techniques known up till now. From the other hand, the coatings, obtained using unfiltered cathodic arc plasma, suffer from a high fraction of macroparticles or droplets generated by cathodic spots simultaneously with neutrals and desired ions of the cathode (target) material. If much larger than the thickness of the main layer, such inclusions represent obvious macroscopic defects that can greatly affect the quality of the films and limit the fields of their possible applications. Thus, a lot of attention through the several decades has been paid to elimination of contamination with macroparticles in the cathodic arc coatings. Historically, the first design of a vacuum arc evaporator was the random arc configuration that is characterized by low motion velocity of the cathode spot. Thus, it generates the largest droplet fraction and demonstrates several issues when performing on the composite targets. The effective method of magnetic filtering of macroparticles was proposed in the 70s by Aksenov and co-workers, see Aksenov et al., "Transport of Plasma Stream in a Curvilinear Plasma-Optics System", Soviet Journal of Plasma Physics 4 (4), 1978, p. 425-428. It utilizes curved (quarter torus shape) magnetic plasma guide where macroparticles together with neutrals are collected on the walls of the filter while the ions and electrons of metallic plasma are driven to the process chamber by the strong axial magnetic field. The result is almost total elimination of the droplet fraction with drastic deterioration of deposition rate that seriously affects the production costs of the coatings.

It is known that the size and amount of macroparticles, produced by the cathode spot, strongly depends on the cathode spot velocity. The increase of cathode spot velocity results in the decrease of droplet fraction and shift of the size distribution towards the smaller particles, that is usually observed, when operating cathode arc plasma sources with reactive background gas, in comparison to high-vacuum pure metallic mode. The motion of the cathode spots can be effectively influenced by applying an external magnetic field. It is strongly enhanced by magnetic field, which lines are parallel to the surface of the target (tangential magnetic field), while the magnetic field, which lines are perpendicular to the surface of the target (normal magnetic field), doesn't demonstrate any obvious influence on the cathode spot velocity. The tangential component of magnetic field is known to provide an intense lateral movement of the cathode spots in antiampere direction, while the gradient of normal component modulus of magnetic field tends to push the cathodic spot in the opposite direction. Together with the acute angle rule these laws provide the basics for all constructions of cathode arc plasma sources with magnetic control known up till now.

The well-known cathode arc evaporator that utilizes the cone-shaped target (known as Bulat-type cathode, RU 2382118 C1) is operated with coaxial magnetic field that becomes axially divergent at the cathode front face. It demonstrates an enhanced arc discharge stability at low-pressure range due to the direct view and low distance between the chamber wall (acting as anode) and large side face of the cone where acute angle rule acts. High velocity of the cathode spot due to the strong magnetic field results in reduced droplet fraction. From the other hand, the strong magnetic field tangential to the both cathode and anode surfaces creates a large voltage drop up to 35 - 40 V that can be an issue for common welding power supplies usually used for vacuum arc deposition. The improper use of the focusing coil placed in front of the target can lead to decrease of the cathode spot velocity on the front face in the normal magnetic field, thus, increasing the droplet fraction. The enhanced thickness of target creates additional overheating of its front surface. The problem with scaling up to larger diameters occurs due to the cone shape. The complicate shape with inner bayonet fastening makes the production of brittle sintered composite targets almost impossible, while the rear part of the cone, made from the other material (stainless steel), leads to possible undesired contamination of plasma and the resulting coating.

The problems mentioned above can be solved using the cathode evaporator with a flat (round or rectangular) target and axially divergent magnetic field applied at the target front face. The main disadvantage of the proposed solution lies in substantially lower values of magnetic field utilized in such case to achieve uniform erosion of the target. In fact, the cathode evaporator must operate in a random arc mode for some time to obtain the homogenous erosion in the center of the target, thus, resulting in a severe contamination of the coating with macroparticles.

As an alternative, the steered arc cathode sources were proposed. A lot of constructions, developed by various inventors, utilize electromagnetic coils with magnetic cores of various forms (US 5298136 and US 5861088) or arrays of permanent magnets (US 9165749 B2), oriented such way to create axially symmetric tangential magnetic field over the largest part of the surface with the same arched closed shape as used in conventional magnetron sputtering. The main disadvantage of the classic steered arc configuration is the formation of deep racetrack on the surface of the target leading to poor target utilization and even to the risk of burnout in the case of cathodic arc. An outer solenoid is often used for partial modification of magnetic field lines distribution over the target surface thus increasing the utilization of the target, but the last one can be hardly achieved even up to 50-60 % remaining most of the material in the center unused up to the end of the target lifecycle. A novel solution is proposed in the invention US 2006/0175190 A1 where the magnetic field, which is tangential over the entire part of the front face of the target, is created with the help of two coils turned on in opposite direction and, thus, compensating the component of the magnetic field normal to the surface of the target. This results in high velocity of the cathode spot over the entire part of the target and leads to homogenous utilization of the target and reduced macroparticles formation. It must be noted that the similar result can be achieved in obsolete cone-shaped Bulat-type cathode arc plasma sources with stabilizing and focusing coils turned on in opposite direction. Two types of cathode spot motion should be distinguished. The first one, which is observed in a conventional steered arc, is related to the circular motion of the cathode spot on the defined radius forming the racetrack of the same radius. The second one is related to the radial movement of a cathode spot and can be observed as a change in radius of the cathode spot circular trajectory. The radial movement of the cathode spot, observed in the invention US 2006/0175190 A1, demonstrates rather random character of motion due to the absence of normal component gradient, that is alternating in time. Thus, a specific oscillation (jamming) of the cathode spot on a fixed radius during a certain time occurs. This leads to overheating of the track on the surface and, thus, to generation of more droplets than can be expected.

Another solution of such a problem is proposed in patent RU 2482217 C1. The basic arched closed magnetic field over the target surface is created by an array of permanent magnets located on the back side of the cathode and provides the basic steered arc motion of the cathode spot closer to the periphery of the target, while the inner pole of the system is driven by the coil and attracts the cathode spot to the center of the target or pushes it to the periphery. Thus, the radial velocity of the cathode spot can be increased up to its natural circular velocity leading to homogenous erosion of the target in time and maintaining the cathode spot location always on the fresh and cooled part of the surface. Nevertheless, issues concerned with the homogeneity of target erosion in the central and outer (above the poles of permanent magnets) regions still remain unresolved. Also, the tangential component of magnetic field in the vicinity of the rim of the target above the poles of permanent magnets changes its direction to opposite that creates an ambiguity in direction of the circular motion of cathode spot. The last one results in skipping of cathode spot, instability of arc discharge and frequent quenching of cathode spots on the rim of the target. Additionally, a certain overheating of permanent magnets in the vicinity of the rim of the target can occur, leading to loss of the permanent magnets force and reducing of magnetic field strength together with all its benefits. Thus, much more expensive and heat resistant SmCo magnets should be used in this type of cathode evaporators.

Document CN 102 936 717 A describes a quasi-diffused cold cathode arc source of plasma that utilizes a somewhat different approach to an arc steering. Here a multipole electromagnet is placed around the target outside the vacuum chamber, and the poles are connected as magnetic dipole. The magnetic field, generated by the multipole electromagnet, has an asymmetric shape in respect to the main axis of the device and is characterized by strong tangential component parallel to the target surface. The cathode spot travels in the radial direction, perpendicular to the magnetic field lines, until it reaches the rim of the target. The circular motion of the cathode spot can be achieved by a rotation of the magnetic field over the time by changing the current in the coils the similar way as in BLDC electric motor. Thus, the signal, applied to the coils, should change in time according to the cathode spot location to prevent an escape of the cathode spot from the front face of the target. The last can be a serious issue, as the intrinsic velocity of the cathode spot is known to depend on the material of the target, working pressure and working gas (reactive or non-reactive) as well as on the arc current. A driver for such multipole electromagnet is expected to be complicate and expensive electronic device, and steering algorithms are not trivial. Reliable feedback of the cathode spot location on the surface of the target is needed for uniform erosion and proper operation of the disclosed device under various conditions, that is almost impossible in real industrial applications.

A unique solution is disclosed in CN 102 953 035 A, where an axially symmetric closed arched magnetic field, dynamically changing in time, is generated with a combination of 2 coils: one of smaller diameter placed together with soft iron yoke behind the target, which generates axially symmetric divergent magnetic field lines in respect to the surface of the target, and the other one of larger diameter placed outside the vacuum chamber in front of the target, which generates axially symmetric convergent magnetic field lines in respect to the surface of the target. The coils are connected in opposite direction in respect to each other to suppress the normal component of magnetic field, which is perpendicular to the surface of the target, and to enhance the tangential component, which is parallel to the surface of the target. In the result of such superposition of divergent and convergent magnetic fields, generated by rear and front coils, the cathode spot location is defined by the area, where the normal component of magnetic field is zero, which corresponds to the apex of an arched magnetic field lines, which is defined by the ratio of current in the coils. Axially symmetric shape provides the circular motion of the cathode spot. Thus, the diameter of the cathode spot circular trajectory can be varied in time by changing the ratio of current in the coils. However, the device, disclosed in CN 102 953 035 A, has a disadvantage of decreased intensity of the tangential component of magnetic field, when operated in the edge zone of the target, that results in the decreased velocity of cathode spot and increased fraction of droplet phase in the generated plasma and the resulting coating. This issue and possible solutions will be demonstrated in the description of the invention.

A vacuum arc source of plasma, disclosed in CN 102 953 035 A, can be improved by addition of the focusing coil with soft iron yoke in front of the convergent front coil according to the document CN 103 205 711 B.

Thus, additional space is formed in front of the target, that can be utilized as straight linear macroparticle filter. The transport and extraction of purified high-density plasma is enhanced thanks to the improved magnetic field distribution in the transmission space.

The advantages and disadvantages of the vacuum arc plasma sources, briefly outlined above, lead to the invention disclosed in the current patent. Therefore, according to the invention there is provided a plasma source according to claims 1 and 2.

### DESCRIPTION OF THE INVENTION

The motion of a cathode spot in presence of magnetic field is known to obey the several rules. The cathode spot is extensively laterally accelerated in antiampere direction in the presence of magnetic field or its component which field lines are parallel to the surface of the target. This results in increased velocity of the cathode spot, easier splitting of the cathode spots at lower values of current, and, finally, reduced formation of droplets. The homogenous magnetic field, which field lines are perpendicular to the surface of the target, doesn't cause any essential influence on the cathode spot motion itself. Nevertheless, the gradient of magnetic field modulus, which is normal to the target surface, is known to drive the cathode spot to an opposite direction. Thus, the cathode spots tend to escape from the areas with stronger normal magnetic field, which field lines are perpendicular to the surface of the target, towards the areas with lower normal magnetic field preferably close to 0. The next, an acute angle rule can be mentioned, that performs in the case of magnetic field lines which intersect the surface of the target at an angle other than 90°. The cathode spot is accelerated in the direction towards acute angle, formed by magnetic field lines and the surface of the target. The rules mentioned above unambiguously explain the tendency of cathode spots to be pushed out to the rim of the target in presence of radially symmetric divergent magnetic field over the surface of the target, or to be attracted to the center in presence of radially symmetric convergent magnetic field. Furthermore, the influence of forces, caused by given rules, compels the cathode spots to stir in antiampere direction preferably under the apex of the closed arch-shaped magnetic field, similar to that one used in conventional magnetron sputtering. Finally, one more force that acts on the cathode spot should be noted. This is the force caused by interaction of the cathode spot current with magnetic field of the current flowing from the cathode spot to the cathode current collector. This force pushes the cathode spot towards the place, where the cathode is connected to power supply, and is often utilized when operating the extended linear, U-shaped, or serpentine-shaped targets at high discharge currents to drive the cathode spots along the target. In case of a round-shaped target with coaxial feedthrough, the given force is directed to the center of the target and creates here the preferred locus of cathode spots, when operated in random arc mode, but it is negligible when operating with strong external magnetic fields utilized in the invention disclosed in current patent.

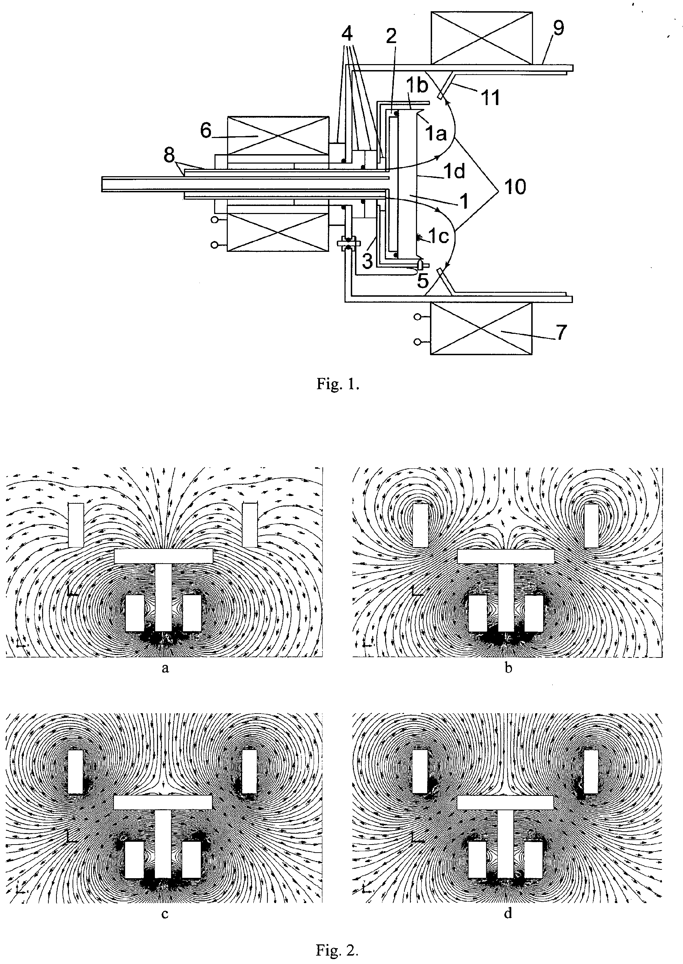

The cathode unit, which utilizes the benefits of various solutions from the state-of-the-art in the field of vacuum arc cathode sources of plasma, is shown in Fig.1 and includes target (1) produced from the desired material. It can be flat or with elevation at the rim for better stabilization of the cathode spot (lc) in the edge zone (la). The elevation has the inner cone shape with inner wall slope 10-80° with respect to the surface of the target. Thus, the magnetic field lines intersect the surface of the inner wall at an optimal acute angle, and the force, caused by acute angle rule, prevents the cathode spots to escape from the face of the target. The water-cooling plate (2), simultaneously functioning as the target holder, is tightened to the target with side locks (not shown in the drawing) such way that only the front surface of the target is exposed to cathode spots and the plasma. Direct cooling of the target is utilized in the invention disclosed herein. Thus, better cooling and less overheating of the surface of the target can be achieved. An electrostatic screen (3), separated from the target and the vacuum chamber wall (9) with insulators (4), eliminates the burning of an arc discharge on the side surface (1b) of the target and the holder. If the cathode spot nevertheless occasionally "jumps" from the front face of the target to the side surface, it is immediately quenched or pushed back as the electrostatic screen is automatically kept at the potential of the target through the resistive element (5) during the operation of the vacuum arc cathode plasma source.

A resistive element (5) for triggering the vacuum arc discharge is placed between the electrostatic screen (3) and the target (1). To trigger an arc discharge at low pressures of working gas or in the "pure" vacuum, the electrostatic screen is grounded for a short period of time or connected to positively charged capacitor. The electrostatic screen becomes an anode for a short period of time, that creates an area with strong electric field in the gap between the target and the electrostatic screen, and optimal conditions for an arc discharge build-up are achieved. Thus, a high-current pulse, flowing through the triggering resistor, evaporates a thin conductive film on its surface, and is followed by ionization of vapors and birth of the cathode spot. The cathode spot is then pushed out of the gap between the target and the electrostatic screen to the front face of the target, as the electrostatic screen gets back the potential of the target through the resistive element.

An electromagnet system consisting of 2 coils: divergent (6) and convergent (7), is utilized for manipulation of the cathode spot motion on the entire surface of the target. A coaxial cooling feedthrough (8), made from material with high magnetic permeability, serves as a ferromagnetic core for the internal pole of electromagnet system, which creates radially symmetric divergent magnetic field over the front face of the target. Divergent magnetic field, created by the coil (6), placed onto the ferromagnetic core (8) behind the target outside the vacuum chamber (9), is utilized for pushing the cathode spot outwards, to the rim of the target, and for imparting it the rotational motion due to the presence of tangential component of axially symmetric divergent magnetic field. The outer auxiliary magnetic field is formed by the coil (7) placed outside the vacuum chamber (9) in front of the target. It deforms the lines of the basic magnetic field, generated by the inner pole of electromagnet system, such way that the resulting arched field (10) is obtained over the surface of the target. Cathode unit can be equipped with the grounded auxiliary anode (11). The lines of the resulting magnetic field cross the surface of additional grounded anode (11) enhancing the stability of an arc discharge at low pressures. Depending on the ratio of currents, passed through the coils, the zone of magnetic field tangential component maximum can be moved from the periphery to the center of the target. Thus, the outer coil (7) acts as a converging element of the electromagnet system, while the inner pole, formed by the inner coil (6) and coaxial feedthrough (8), acts as a diverging element for the cathode spot circular racetrack. When the apex of an arch, formed with magnetic field lines, is shifted to the rim of the target, the magnetic field lines intersect the inner wall of the elevation at the rim of the target at an acute angle of 10-80°, and the resulting force pulls the cathode spot in the direction towards the center of the target and, thus, prevents it from escape out the target front face. The mentioned situation, that corresponds to the maximum of the divergent coil current and to the minimum of the convergent coil current, is illustrated in Fig.2a. The increase of current in the convergent coil leads to contraction of the arch apex of magnetic field lines to the center of the target (Fig.2b and Fig.2c) together with the cathode spot locus. An intensive erosion of the central part of the target is observed, when operating with divergent and convergent coils at maximal values of currents passed through them (Fig.2d), in contradiction to the classic steered arc sources of plasma, where a specific island in the center of the target always remains unused.

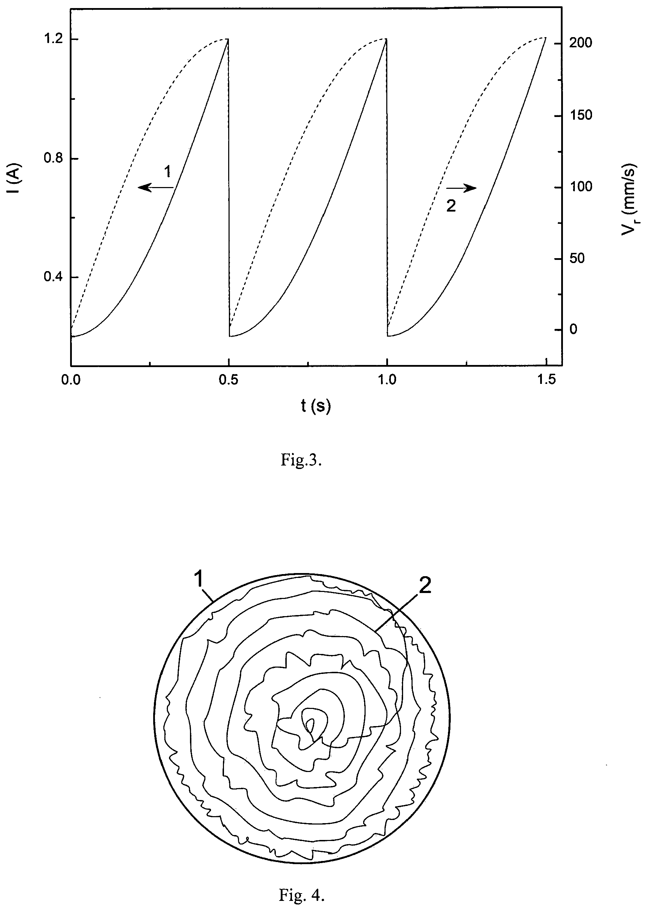

An almost uniform erosion of the target can be achieved by passing the current with an appropriate current waveform to the coils (Fig.3 (1)) in comparison to the configuration with permanent magnets located behind the target in convenient steered arc cathode source evaporator. As the locus of cathode spot and the radius, on which the maximal erosion occurs, depend on the currents' ratio in the divergent and convergent coils, a time-varying current can be passed through the coils to drive the cathode spot in time by an optimal way. Considering the divergent coil containing say 1000 turns to be operated in DC mode with the constant current of say 1A, the convergent coil containing say 500 turns should be operated with current, that changes in time between the 2 values that correspond to the cathode spot location at the rim and in the center of the target, which are 0.2 A and 2.2 A respectively in the example under consideration. It should be considered that the area, traveled by cathode spot in the unit of time, decreases when approaching the center of the target. This leads to more intensive erosion, surface overheating, and undesirable transfer of cathode spot from the first to the second mode in the case of reactive deposition, and, finally, to increase of undesirable droplet fraction content in plasma streams. Thus, the radial velocity of cathode spot must be increased while the cathode spot travels closer to the center of the target. A quarter of sine current waveform, repeated in time, with defined frequency complies well with the mentioned requirements. Dashed line (2) in Fig.3 demonstrates an increase of radial velocity in the vicinity of the target center. The frequency of the current waveform should be at least a few times less in comparison to the natural circular frequency of the cathode spot and can be evaluated visually for every set of process conditions that affect the cathode spot velocity (such as strength of magnetic field, working pressures, reactive atmosphere, or material of the target) following the cathode spot trajectory illustrated in Fig.4.

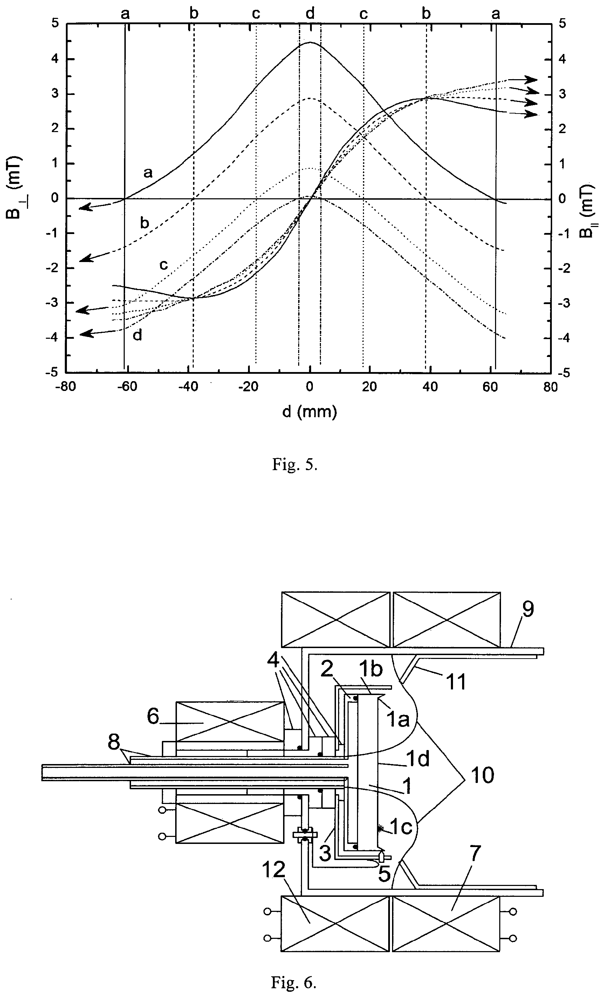

The velocity of cathode spot is enhanced, when applying the field from both inner divergent coil and outer convergent coil, due to adding of the unidirectional tangential components of magnetic field from the 2 coils in the vicinity of the surface of the target, while the normal components of magnetic field cancel each other in the defined area. The area of the maximal likelihood of cathode spot location corresponds to the minimum of the module of magnetic field normal component (the place, where magnetic field lines are parallel to the surface of the target, as marked by vertical lines in Fig.5). As a net effect, the cathode spot doesn't lose its velocity even in the central region of the target, which is known to be the most problematic one.

In addition, the front convergent coil creates focusing magnetic field in front of the surface of the target resulting in increased ionization and droplet fraction mass loss (partial evaporation of droplets due to intensified plasma contraction and heating). Focusing magnetic field enhances the transport of plasma to the process chamber and can be utilized in various straight-line or curved macroparticles filters. Thus, the proposed construction utilizes the benefits of steered arc cathodes with additional focusing effect of the outer coil on plasma. The final effect is enhanced uniformity of the target erosion and reduced droplet fraction in metal plasma generated by vacuum arc cathode plasma source.

The cathode spot is moving closer to the rim of the target, when the current of convergent coil reaches its minimum, while the strength of divergent magnetic field, generated by inner pole, is attenuated far from the center of the target. This results in a certain decrease of cathode spot velocity at the rim of the target. The intensity of tangential component of magnetic field in the edge zone of the target is decreased from approximately 3.5 mT to 2.5 mT when conditions for operating in the edge zone of the target are fulfilled (Fig.5(a)). The strength of tangential magnetic field at the rim of the target can be increased by addition of the third coil (12) of the same dimensions as the convergent coil but connected in opposite polarity in respect to the convergent coil (7), as presented in Fig.6. In this case the component of the magnetic field, that is normal to the surface of the target, is additionally suppressed, while the tangential component of the resulting magnetic field, that is parallel to the surface of the target, is enhanced by adding the unidirectional tangential field components. In this case, the current in divergent and convergent coils is fixed constant say 1 A and 2.4 A correspondingly, while the current in the additional coil (7) is changed from 0 to 2.3 A to drive the cathode spot from the center to the rim of the target. As a result, the tangential component of magnetic field in the edge zone of the target is increased more than 2 times (up to 6 mT) when conditions for operating at the rim of the target are fulfilled, that leads to an increase of cathode spot velocity at the rim of the target.

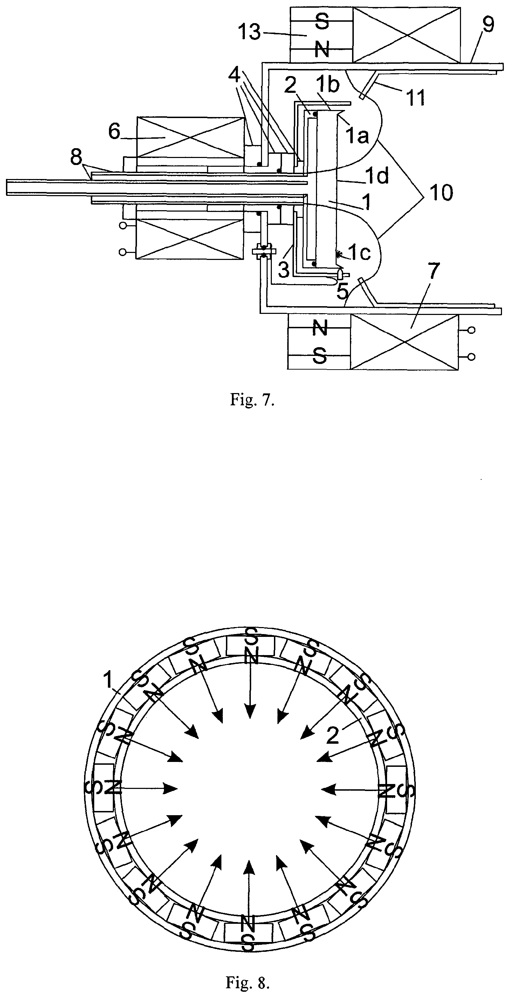

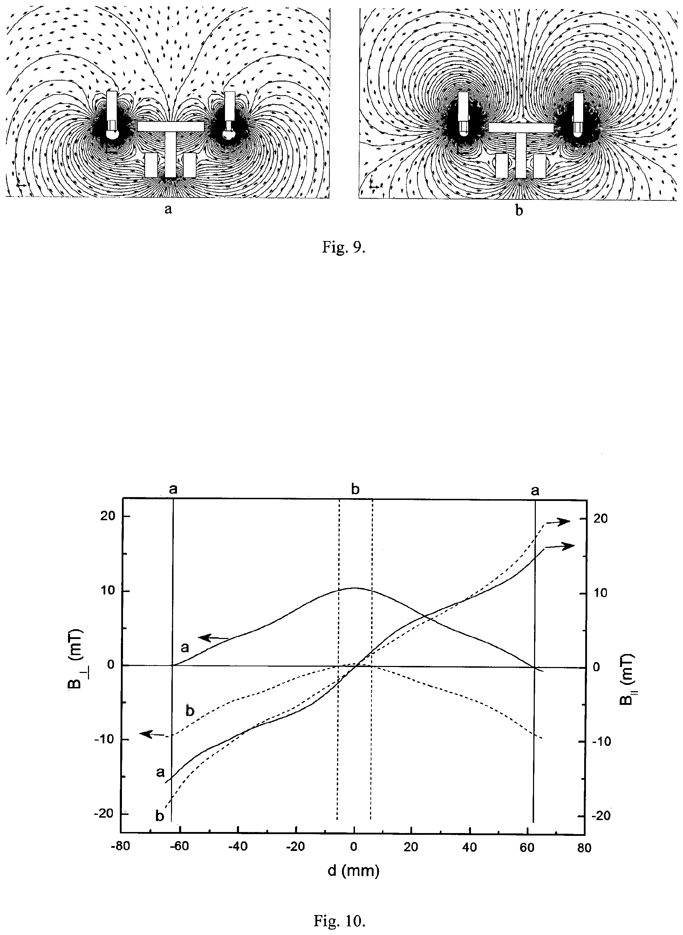

The basic vacuum arc cathode assembly according to Fig.1 can be alternatively modified with a radially oriented permanent magnet array (13) in the form of a collar encircling the vacuum chamber wall of the cathode assembly and located behind the converging front coil on the same level as the surface of the target as shown in Fig.7. The array, mentioned above, can be assembled from the low-cost rectangular rare-earth (NdFeB) permanent magnets according to Fig.8 placed between outer (1) an inner (2) poles in the form of rings, made from iron or soft magnetic steel with high magnetic permeability, and unipolarly oriented to the center. The field, created by such magnet array, is axially symmetric and parallel to the surface of the target. It ensures the fast motion of cathode spot in lateral direction, but the radial motion demonstrates rather random character. This basic magnetic field can be deformed in a desired way by the divergent and convergent coils to perform the intensive scanning of the surface of the target by the cathode spot (Fig.9). As a result, the tangential component of magnetic field in the edge zone of the target is increased more than 5 times (up to 15 mT) when the conditions for operating at the rim of the target are fulfilled (Fig.10 (a)), that leads to an even stronger increase of cathode spot velocity at the rim of the target. The advantage of such modification lies in the absence of the third coil which needs additional controllable power source. Since the permanent magnets are located outside the vacuum chamber and protected from plasma by water-cooled chamber wall, the radially oriented array can utilize cheaper NdFeB magnets instead of expensive SmCo magnets which can withstand elevated temperatures.

### DESCRIPTION OF THE DRAWINGS

Fig. 1. General vacuum arc cathode assembly with 2 coils according to the state-of-the-art.
Fig. 2. Magnetic field lines formed by electromagnet system, presented in Fig. 1, at various current ratios in the divergent Id and convergent Ic coils:
   a - Id= +1 A / Ic = -0.2 A, b - Id= +1 A / Ic = -1 A, c - Id= +1 A / Ic = -2 A, d - Id= +1 A / Ic = -2.2 A.
Fig. 3. Waveforms of the convergent coil current (1) and the cathode spot radial velocity (2) optimized for more homogenous erosion of the target and reduced generation of droplets.
Fig. 4. Approximate image of cathode spot track with convergent coil current waveform according to Fig. 3.
Fig. 5. Radial distribution of normal B⊥ and tangential B∥ components of magnetic field in the vicinity of the front surface of the target at various current ratios in the driving coils according to Fig. 2.
Fig. 6. Modification of the basic electromagnet system according to Fig.1 with the second outer coil for enhanced field distribution at the rim of the target.
Fig. 7. Alternative modification of the basic electromagnet system according to Fig.1 with outer permanent magnet array in form of collar.
Fig. 8. The face view of the outer permanent magnet array in the form of collar according to Fig. 7.
Fig. 9. Magnetic field lines formed by electromagnet system, modified with outer permanent magnet array according to Fig. 7, at various current ratios in the divergent Id and convergent Ic coils: a - Id = +1 A / Ic = +2.5 A, b - Id = +1 A / Ic = -2.8 A.
Fig. 10. Radial distribution of normal B⊥ and tangential B∥ components of magnetic field in the vicinity of the front surface of the target at various current ratios in the driving coils according to Fig. 9.

### EXAMPLES

Fig.1 depicts the basic configuration of vacuum arc cathode source of plasma described herein. The cathode unit includes a target (1) with elevated rim for better stabilization of cathode spot (lc) in the edge zone (la), a water-cooling plate (2), simultaneously functioning as a target holder, that provides direct water cooling of the target, an electrostatic screen (3) separated from the target and the vacuum chamber wall with insulators (4) for elimination of arc burning on the side surface (1b) of the target and holder (2), a resistive element (5) for triggering a vacuum arc discharge, and an electromagnet system consisting from 2 coils: divergent (6) and convergent (7), for manipulation of cathode spot motion. The coaxial cooling feedthrough (8) serves also as a ferromagnetic core for the internal divergent field electromagnet. The internal divergent magnetic field is created by the coil (6), placed onto the ferromagnetic core (8) behind the target outside the vacuum chamber, and is utilized for pushing the cathode spot outwards to the rim of the target and imparting it a rotational motion due to presence of tangential component of axially symmetric divergent magnetic field. The outer convergent magnetic field is formed by the coil (7) placed outside the vacuum chamber (9) in front of the target. It deforms the lines of basic magnetic field, generated by the inner pole of electromagnet system, such way that the resulting arched field (10) is obtained over the surface of the target. The lines of the resulting magnetic field cross the surface of additional grounded anode (11) enhancing the stability of an arc discharge at low pressures. Depending on the ratio of currents passed through the coils, the zone of magnetic field tangential component maximum can be moved from the periphery to the center of the target. Thus, the outer coil (7) acts as converging element of the proposed electromagnet system while the inner pole, formed by the inner coil (6) and coaxial feedthrough (8) acts as diverging element for the circular racetrack formed by cathode spot.

In Fig.2 the vector lines of magnetic field, formed by divergent and convergent coils at different current values in convergent coil, are shown as an example. It can be seen that the increase of current in external convergent coil, located in front of the target, from 0.2 A up to 2.2 A (from (2a) to (2d)) leads to contracting of the area where magnetic field lines are parallel to the surface of the target. The apex of the arch formed by magnetic field lines is also shifted towards the center of the target together with the locus of cathode spot and zone of maximal erosion.

In Fig.3 an optimized waveform of time-varying current in the convergent coil is shown. As the locus of cathode spot and the radius, on which the maximal erosion occurs, depends on the currents' ratio in divergent and convergent coils, a time-varying current can be passed through one of the coils to drive the cathode spot in time in an optimal way. The divergent coil is operated in DC mode with constant current of 1 A, while the convergent coil is operated with current that changes in time between the 2 values of 0.2 A and 2.2 A which correspond to the cathode spot location at the rim and in the center of the target respectively. It should be considered that the area, traveled by cathode spot in the unit of time, decreases when approaching the center of the target. Thus, the radial velocity must be increased while the cathode spot travels closer to the center of the target. A quarter of sine current waveform (Fig.3 (1)), repeating in time with defined frequency, complies well with the mentioned requirements. Dashed line (2) in Fig.3 demonstrates an increase of radial velocity of cathode spot in the vicinity of the target center. The frequency of the current waveform should be at least a few times less in comparison to the natural circular frequency of the cathode spot defined by its intrinsic linear velocity.

Fig.4 illustrates the cathode spot track when optimized current waveform is applied to the convergent coil according to Fig.3. The track represents a converging flat spiral (Fig.4 (2)) with closely located turns starting from the rim of the target (Fig.4 (1)) and ending in the center, followed by "jump" back to the rim of the target in the end of each cycle.

Fig.5 demonstrates the behavior of the resulting magnetic field with change in the ratio of currents in coils (6) and (7) in accordance to Fig.2 in somewhat other representation - the changes in radial profile of normal magnetic field component B⊥, perpendicular to the front surface of the target, versus the changes in radial profile of tangential magnetic field component B∥ parallel to the front surface of the target. The strength of tangential magnetic field component decreases to 0 in direction to the center of the target and changes its direction to the opposite due to its radial symmetry, while the increase of convergent coil current in front of the target causes only slight changes in the profile of tangential magnetic field component predominantly at the rim of the target. At the same time the radial profile of normal magnetic field component is shifted downward but retains its original shape. The locus of the cathode spot is defined by the radius, where the value of B⊥ is close to 0 or has the lowest gradient otherwise, and is marked by vertical lines.

Fig.6 depicts the basic configuration of vacuum arc cathode source of plasma according to Fig.1, additionally modified with second outer coil (12) located backside the convergent front coil (7) and turned on with opposite polarity in respect to the convergent front coil. The normal components B⊥ of coils (7) and (12) cancel each other, while the tangential components B∥ are added. This increases the cathode spot velocity at the rim of the target (up to 6 mT) where the magnetic field from the basic divergent coil (6) is comparatively weak (2.5 mT).

Fig.7 depicts modified vacuum arc cathode source of plasma in accordance with Fig.6 where the additional coil (12) is substituted with radially oriented permanent magnet array (13) in the form of a collar which creates magnetic field similar to the magnetic field of two coils turned on in opposite directions. This eliminates the requirement of additional driver for the coil and increases the effective strength of magnetic field.

Fig.8 shows the radially oriented permanent magnet array collar utilized in the modified vacuum arc cathode source of plasma according to Fig.7 in face view. Permanent magnet array collar comprises outer (1) and inner (2) ring poles made from soft magnetic steel and permanent magnets pressed between them. The direction of magnetic field lines is shown with arrows.

In Fig.9 magnetic field lines, generated by the electromagnet system modified with radially oriented permanent magnet array according to Fig.8, are illustrated in two outermost cases. In the first case (Fig.9a) the locus of cathode spot is shifted to the rim of the target. In contrast to the basic configuration of electromagnet system according to Fig.1, where the convergent front coil should operate with the lowest value of current to get the cathode spot locus on the rim of the target, a large current (2.5 A in an example) should be passed through the convergent coil in the same direction as in the divergent coil in the presence of field generated by permanent magnet array. In the second case (Fig.9b) the locus of cathode spot is shifted to the center of the target. The convergent front coil should operate with reversed polarity in respect to the divergent coil but with somewhat higher value of current (2.8 A in an example) passed through it in comparison to the basic configuration. The benefit of such modification consists in fact that the stronger focusing field of convergent coil is present for a longer period of time during every period.

In Fig.10 a radial distribution of normal B⊥ and tangential B∥ components of magnetic field in the vicinity of the front surface of the target at various current ratios in the driving coils is given according to Fig.9. The values of tangential B∥ component of magnetic field in the presence of radially oriented permanent magnet array are more than 5 times higher in comparison to the values shown in Fig.5 that results in 5 times higher cathode spot velocity. Thus, the quality of the resulting coatings is enhanced much more comparing to the basic configuration according to Fig.1.

### INDUSTRIAL APPLICABILITY

The present invention relates to a plasma source utilizing a cathodic vacuum arc discharge and a method for operating it, wherein the source provides control of an arc discharge for plasma surface treatment.

## Claims

1. Plasma source, utilizing cathodic vacuum arc discharge, that comprises: a water cooled vacuum chamber (9) with a vacuum chamber wall (9); a target (1) with elevated rim for better stabilization of the cathode spot in the edge zone (1a), a water-cooling plate (2) that in the same time serves as the target holder, an electrostatic screen (3) separated from the target and the vacuum chamber wall (9) with insulators (4) for prevention of arc burning on the side surface (1b) of the target and holder, a resistive element (5) placed between the target (1) and the electrostatic screen (3) for triggering a vacuum arc discharge, a system of electromagnets comprising 2 coils: a divergent coil (6), placed outside the vacuum chamber on a coaxial feedthrough (8) behind the target (1), and a convergent coil (7) placed in front of the target's front face (1d) outside the vacuum chamber, the coaxial cooling feedthrough (8) that serves in the same time as a ferromagnetic core for the divergent coil (6), an additional grounded anode (11) to enhance the stability of vacuum arc discharge at low pressures, and the water cooled vacuum chamber (9) enclosing the target, fixed on the water cooled target holder, the electrostatic screen, the resistive element, and the additional anode wherein an additional coil (12) is placed directly behind the convergent front coil (7) outside the vacuum chamber.

2. Plasma source according to claim 1, wherein an additional collar (13) with radially oriented set of permanent magnets is placed directly behind the convergent front coil (7) outside the vacuum chamber (9)instead of the additional coil (12) in such a way that the poles are oriented in radial direction in the same plane as the front face of the target (1b).

## Patentansprüche

1. Plasmaquelle, die eine kathodische Vakuumbogenentladung nutzt, bestehend aus: einer wassergekühlten Vakuumkammer (9) mit einer Vakuumkammerwand (9); einem Target (1) mit erhöhtem Rand zur besseren Stabilisierung des Kathodenpunkts in der Randzone (la), einer Wasserkühlungsplatte (2), die gleichzeitig als Targethalter dient, einer elektrostatischen Abschirmung (3), die vom Target und der Vakuumkammerwand (9) mit Isolatoren (4) zur Verhinderung von Lichtbogenbrennen an der Seitenfläche (1b) des Targets und des Halters getrennt ist, einem Widerstandselement (5), das zwischen dem Target (1) und der elektrostatischen Abschirmung (3) angeordnet ist, um eine Vakuumlichtbogenentladung auszulösen, einem System von Elektromagneten, das 2 Spulen umfasst: eine divergente Spule (6), die außerhalb der Vakuumkammer an der koaxialen Durchführung (8) hinter dem Target angeordnet ist, und eine konvergente Spule (7), die vor der Vorderseite (Id) des Targets außerhalb der Vakuumkammer angeordnet ist, einer koaxialen Kühlungsdurchführung (8), die gleichzeitig als ferromagnetischer Kern für die divergente Spule (6) dient, einer zusätzlichen geerdeten Anode (11) zur Verbesserung der Stabilität der Vakuumlichtbogenentladung bei niedrigen Drücken, und einer wassergekühlten Vakuumkammer (9), die das Target umschließt, das auf dem wassergekühlten Target-Halter, der elektrostatischen Abschirmung, dem Widerstandselement und der zusätzlichen Anode befestigt ist, wobei eine zusätzliche Spule (12) direkt hinter der konvergenten Frontspule (7) außerhalb der Vakuumkammer angeordnet ist.

2. Plasmaquelle gemäß Anspruch 1, wo eine zusätzliche Muffe (13) mit einer radial ausgerichteten Reihe von Permanentmagneten direkt hinter der konvergente Frontspule (7) außerhalb der Vakuumkammer anstelle der zusätzlichen Spule (12) so angeordnet ist, dass die Pole in radialer Richtung in derselben Ebene wie die Vorderseite des Targets (1b) ausgerichtet sind.

## Revendications

1. Source de plasma utilisant une décharge à arc sous vide cathodique, comprenant : une chambre à vide (9) refroidie à l'eau avec une paroi de chambre à vide (9); une cible (1) avec un bord surélevé pour une meilleure stabilisation de la tache cathodique dans la zone périphérique (1a), une plaque de refroidissement à eau (2) qui sert en même temps de porte-cible, un écran électrostatique (3) séparé de la cible et de la paroi de la chambre à vide (9) par des isolateurs (4) pour empêcher la formation d'arc sur la surface latérale (1b) de la cible et du porte-cible, un élément résistif (5) placé entre la cible (1) et l'écran électrostatique (3) pour l'amorçage d'une décharge à arc sous vide, un système d'électroaimants comprenant 2 bobines : une bobine divergente (6), placée à l'extérieur de la chambre à vide sur une traversée coaxiale (8) derrière la cible (1), et une bobine convergente (7) placée devant la face avant de la cible (1d) à l'extérieur de la chambre à vide, la traversée de refroidissement coaxiale (8) servant en même temps de noyau ferromagnétique pour la bobine divergente (6), une anode supplémentaire mise à la terre (11) pour améliorer la stabilité de la décharge à arc sous vide aux basses pressions, et la chambre à vide refroidie à l'eau (9) renfermant la cible, fixée sur le porte-cible refroidi à l'eau, l'écran électrostatique, l'élément résistif et l'anode supplémentaire, dans laquelle une bobine supplémentaire (12) est placée directement derrière la bobine avant convergente (7) à l'extérieur de la chambre à vide..

2. Source de plasma selon la revendication 1, dans laquelle un collier supplémentaire (13) avec un ensemble d'aimants permanents orientés radialement est placé directement derrière la bobine avant convergente (7) à l'extérieur de la chambre à vide (9) à la place de la bobine supplémentaire (12), de telle sorte que les pôles soient orientés dans une direction radiale dans le même plan que la face avant de la cible (1b).
